# EUROPEAN PATENT APPLICATION

(11) **EP 4 779 283 A1**
(43) Date of publication of application: **22.07.2026**
(21) Application number: 24947787.8
(22) Date of filing: 24.12.2024
(51) Int. Cl.: G01L 9/12, B81B 3/00, G01L 13/06, G01L 1/14, B81B 7/02

(54) **MEMS PRESSURE SENSOR AND MANUFACTURING METHOD THEREFOR, AND ELECTRONIC DEVICE**

(30) Priority: 17.07.2024 CN 202410966204
(71) Applicant: China Resources Microelectronics Holdings Limited, Jingan District Shanghai 200072 (CN)
(72) Inventor: JIN, Wenchao, Shanghai 200072 (CN); LI, Shaoping, Shanghai 200072 (CN); ZHU, Encheng, Shanghai 200072 (CN); GAO, Duoduo, Shanghai 200072 (CN); HU, Yonggang, Shanghai 200072 (CN); YAN, Kai, Shanghai 200072 (CN); DONG, Yang, Shanghai 200072 (CN)
(74) Representative: HGF
(86) International application number: PCT/CN2024/141763
(87) International publication number: WO 2026/016412

(57) **Abstract**

A MEMS pressure sensor, a manufacturing method therefor, and an electronic device are provided in this application. The method includes providing a first substrate and a second substrate. A first pressure structure is formed on the first substrate. A second pressure structure is formed on the second substrate. The first pressure structure and the second pressure structure are bonded. The first substrate is removed to expose the first pressure structure, and the first pressure structure and the second pressure structure collectively form a third pressure structure. The third pressure structure includes a first electrode layer, a second electrode layer, a third electrode layer, a fourth electrode layer, and a fifth electrode layer, which are spaced apart from top to bottom. Dielectric layers are formed between respective adjacent electrode layers. Cavities penetrating respective dielectric layers are formed.

## Description

### RELATED APPLICATION

The present application claims priority to Chinese patent No. 202410966204.4, filed on July 17, 2024, entitled "MEMS PRESSURE SENSOR, MANUFACTURING METHOD THEREFOR, AND ELECTRONIC DEVICE", and the content of which is hereby incorporated by reference in its entirety.

### TECHNICAL FIELD

The present application relates to the technical field of semiconductors, in particular to a MEMS pressure sensor, a manufacturing method therefor, and an electronic device.

### BACKGROUND

Micro-electro-mechanical system (MEMS) pressure sensors represent a cutting-edge research field developed on the basis of MEMS process. The sensors are suitable for harsh environments such as high impact, high overload, conductive, corrosive, and radioactive conditions, and are widely applied in fields such as aerospace, electronics, industry, medical healthcare, and environmental monitoring. Compared with piezoresistive pressure sensors, capacitive pressure sensors offer advantages such as high sensitivity, low power consumption, and good temperature characteristics, thus being widely used in various fields.

According to the capacitance formula, capacitive pressure sensors can be further divided into three types: spacing-variable type, area-variable type, and dielectric-variable type. Due to ease implementation, spacing-variable capacitive pressure sensors are most common. Its principle is that changes in spacing lead to changes in capacitance values, and then amplification is performed after integrated circuits acquire signals.

### SUMMARY

In the Summary section, a series of simplified concepts are introduced, which shall be further elaborated in the Detailed Description section. The Summary section of this application is not intended to limit critical or essential technical features of the claimed technical solution, nor is it intended to define the protection scope of the claimed technical solution.

In view of the technical problems present in related art, a manufacturing method for a micro-electro-mechanical system (MEMS) pressure sensor is provided in an aspect of the present application. The manufacturing method includes the followings.

A first substrate and a second substrate are provided. A first pressure structure is formed on the first substrate. A second pressure structure is formed on the second substrate. The first pressure structure and the second pressure structure are bonded. The first substrate is removed to expose the first pressure structure. A third pressure structure is formed by the first pressure structure and the second pressure structure collectively. The third pressure structure includes a first electrode layer, a second electrode layer, a third electrode layer, a fourth electrode layer, and a fifth electrode layer. These electrode layers are spaced apart from top to bottom. Dielectric layers are formed between respective pairs of adjacent electrode layers. Cavities penetrating respective dielectric layers are formed in the dielectric layers. Each electrode layer except the second electrode layer is formed with vias penetrating the respective electrode layer. Alternatively, each electrode layer except the third electrode layer is formed with vias penetrating the respective electrode layer. Alternatively, each electrode layer except the fourth electrode layer is formed with vias penetrating the respective electrode layer. The vias are exposed by the cavities. A first capacitor is formed by the first electrode layer and the second electrode layer. A second capacitor is formed by the second electrode layer and the third electrode layer. A third capacitor is formed by the third electrode layer and the fourth electrode layer. A fourth capacitor is formed by the fourth electrode layer and the fifth electrode layer. A Wheatstone bridge is formed by the first capacitor, the second capacitor, the third capacitor, and the fourth capacitor.

In some embodiments, a dielectric layer is formed on at least one of the bonding surfaces of the first pressure structure and the second pressure structure. The first pressure structure and the second pressure structure are bonded by the dielectric layer.

In some embodiments, the bonding is performed by a low-temperature vacuum bonding process.

In some embodiments, in a case where each electrode layer except the third electrode layer is formed with vias penetrating the respective electrode layer, the vias in the first electrode layer and the vias in the second electrode layer are staggered with each other.

In some embodiments, in a case where each electrode layer except the fourth electrode layer is formed with vias penetrating the respective electrode layer, the vias in the first electrode layer, the vias in the second electrode layer, and the vias in the third electrode layer are staggered with each other.

In some embodiments, the first pressure structure includes the first electrode layer and the second electrode layer. The second pressure structure includes the third electrode layer, the fourth electrode layer, and the fifth electrode layer. During the bonding, a side of the first pressure structure, on which the second electrode layer is formed, is bonded to a side of the second pressure structure, on which the third electrode layer is formed. Each electrode layer except the second electrode layer is formed with vias penetrating the respective electrode layer.

In some embodiments, the first pressure structure includes the first electrode layer, the second electrode layer, and the third electrode layer. The second pressure structure includes the fourth electrode layer and the fifth electrode layer. During the bonding, a side of the first pressure structure, on which the third electrode layer is formed, is bonded to a side of the second pressure structure, on which the fourth electrode layer is formed. Each electrode layer except the third electrode layer is formed with vias penetrating the respective electrode layer.

In some embodiments, the first pressure structure includes the first electrode layer, the second electrode layer, the third electrode layer, and the fourth electrode layer. The second pressure structure includes the fifth electrode layer. During the bonding, a side of the first pressure structure, on which the fourth electrode layer is formed, is bonded to a side of the second pressure structure, on which the fifth electrode layer is formed. Each electrode layer except the third electrode layer is formed with vias penetrating the respective electrode layer.

In some embodiments, connection layers are respectively formed between the first substrate and the first electrode layer, and between the second substrate and the fifth electrode layer.

In some embodiments, materials of the connection layers include silicon oxide, nitride, or oxynitride.

In some embodiments, the vias are formed by a dry etching process or a wet etching process.

In some embodiments, the first capacitor, the second capacitor, the third capacitor, and the fourth capacitor are vertically integrated.

In some embodiments, the first capacitor and the second capacitor are capacitors with a variable capacitance, and the third capacitor and the fourth capacitor are reference capacitors with a fixed capacitance. Alternatively, the second capacitor and the third capacitor are capacitors with a variable capacitance, and the first capacitor and the fourth capacitor are reference capacitors with a fixed capacitance. Alternatively, the third capacitor and the fourth capacitor are capacitors with a variable capacitance, and the first capacitor and the second capacitor are reference capacitors with a fixed capacitance.

A micro-electro-mechanical system pressure sensor is provided in another aspect of the present application. The pressure sensor includes a substrate and a pressure structure. The pressure structure is arranged above the substrate and includes a first electrode layer, a second electrode layer, a third electrode layer, a fourth electrode layer, a fifth electrode layer. These electrode layers are spaced apart from top to bottom. Dielectric layers are formed between respective pairs of said electrode layers. Cavities penetrating respective dielectric layers are formed therein.

Each electrode layer except the second electrode layer is formed with vias penetrating the respective electrode layer. Alternatively, each electrode layer except the third electrode layer is formed with vias penetrating the respective electrode layer. Alternatively, each electrode layer except the fourth electrode layer is formed with vias penetrating the respective electrode layer. The vias are exposed by the cavities.

A first capacitor is formed by the first electrode layer and the second electrode layer. A second capacitor is formed by the second electrode layer and the third electrode layer. A third capacitor is formed by the third electrode layer and the fourth electrode layer. A fourth capacitor is formed by the fourth electrode layer and the fifth electrode layer. A Wheatstone bridge is formed by the first capacitor, the second capacitor, the third capacitor, and the fourth capacitor.

In some embodiments, in a case where each electrode layer except the third electrode layer is formed with vias penetrating the respective electrode layer, the vias in the first electrode layer and the vias in the second electrode layer are staggered with each other. In a case where each electrode layer except the fourth electrode layer is formed with vias penetrating the respective electrode layer, the vias in the first electrode layer, the vias in the second electrode layer, and the vias in the third electrode layer are staggered with each other.

An electronic device is provided in yet another aspect of the present application. The electronic device includes the aforesaid micro-electro-mechanical system pressure sensor.

Benefits of the Micro-electro-mechanical system, the manufacturing method therefor, and the electronic device in the embodiments of the present application can be realized as the followings. By bonding the first pressure structure and the second pressure structure to obtain the third pressure structure. The third pressure structure includes the first electrode layer, the second electrode layer, the third electrode layer, the fourth electrode layer, and the fifth electrode layer. These electrode layers are spaced apart from top to bottom. The first capacitor is formed by the first electrode layer and the second electrode layer. The second capacitor is formed by the second electrode layer and the third electrode layer. The third capacitor is formed by the third electrode layer and the fourth electrode layer. The fourth capacitor is formed by the fourth electrode layer and the fifth electrode layer. The Wheatstone bridge is formed by the first capacitor, the second capacitor, the third capacitor, and the fourth capacitor, that is, a vertically integrated Wheatstone bridge, which improves the measurement accuracy of the MEMS pressure sensor while reducing the planar size thereof, thereby improving the integration density of devices and reducing costs.

### BRIEF DESCRIPTION OF THE DRAWINGS

In order to more clearly illustrate the technical solutions in the embodiments of the present application or related technologies, the accompanying drawings required for describing the embodiments or related technologies are briefly introduced below. Obviously, the drawings described below merely involve some embodiments of the present application. For those skilled in the art, other accompanying drawings may also be obtained from these accompanying drawings without inventive efforts.
FIG. 1 is a flowchart of a manufacturing method for a MEMS pressure sensor according to an embodiment in the present application.
FIG. 2A to FIG. 2C are schematic cross-sectional views of devices sequentially obtained by performing a manufacturing method for a MEMS pressure sensor according to some embodiments in the present application.
FIG. 3A to FIG. 3C are schematic cross-sectional views of devices sequentially obtained by performing a manufacturing method for a MEMS pressure sensor according to some other embodiments in the present application.
FIG. 4A to FIG. 4C are schematic cross-sectional views of devices sequentially obtained by performing a manufacturing method for a MEMS pressure sensor according to yet some other embodiments in the present application.
FIG. 5 is a schematic diagram of a circuit structure of a Wheatstone bridge in the embodiment shown in FIG. 2C.

### DETAILED DESCRIPTION

The present application is described more clearly hereinafter in conjunction with the accompanying drawings in which embodiments of the application are shown. However, the technical solutions of the present application may be implemented in various forms and should not be construed as limited to the embodiments set forth herein. Rather, provided embodiments make this disclosure being thorough and complete, and will fully convey the scope of the present application to those skilled in the art. In the accompanying drawings, the dimensions and relative dimensions of layers and regions may be exaggerated for clarity. Same reference numerals refer to the same elements throughout.

It should be understood that when an element or layer is referred to as being "on", "adjacent to", "connected to", or "coupled to" another element or layer, the element or layer can be directly on, adjacent to, connected to, or coupled to the other element or layer, or intervening elements or layers may be present. In contrast, when an element is referred to as being "directly on", "directly adjacent to", "directly connected to", or "directly coupled to" another element or layer, there is no intervening element or layer present. It should be understood that although the terms such as first, second, and third can be used herein to describe various elements, components, regions, layers, and/or parts, these elements, components, regions, layers, and/or parts should not be limited by these terms. These terms are only used to distinguish an element, a component, a region, a layer, or a part from another element, component, region, layer, or part. Thus, first elements, first components, first regions, first layers, or first parts described below can be referred to as second elements, second component, second region, second layer, or second parts without departing from the teachings of the present application.

Spatial relationship terms such as "under", "below", "lower", "beneath", "over", and "upper" are used herein for convenience of description to describe the relationship of an element or feature to another element or feature as illustrated in the accompanying drawings. It should be understood that the spatial relationship terms are intended to encompass different orientations of the elements in use or operation in addition to the orientations depicted in the drawings. For example, if an element in the drawings is flipped, elements or features described as "below other elements", "beneath them", or "under them" shall be oriented "above" other elements or features. Thus, the exemplary terms "below" and "under" can include both upward and downward orientations. The element may be otherwise oriented (rotated 90 degrees or at other orientations) and the spatial descriptors used herein interpreted accordingly.

The terms used herein is for the purpose of describing specific embodiments only and is not intended to limit the present application. As used herein, the singular forms "a", "an", and "the/said" are intended to include the plural forms as well, unless the context clearly indicates otherwise. It should be further understood that the terms "consist of" and/or "comprise", when used in this specification, the presence of features, integers, steps, operations, elements, and/or components are specified, but do not preclude the presence or addition of one or more other features, integers, steps, operations, elements, components, and/or groups thereof. As used herein, the term "and/or" includes any and all combinations of the associated listed items.

In order to provide a thorough understanding of the present application, detailed steps and structures are provided in the following description to illustrate the technical solutions provided in the present application. Some embodiments of the present application are described in detail below. However, the present application may have other implementations in addition to these detailed descriptions.

In related art, for spacing-variable capacitive pressure sensors, single capacitive structures are generally used to measure pressure. However, the single capacitive structures have low measurement accuracy, which is unfavorable for mass production. In order to improve measurement accuracy, a planar bridge capacitive structure is often used. However, the planar bridge capacitive structure increases the planar size of the devices, leading to area waste, thereby increasing manufacturing costs.

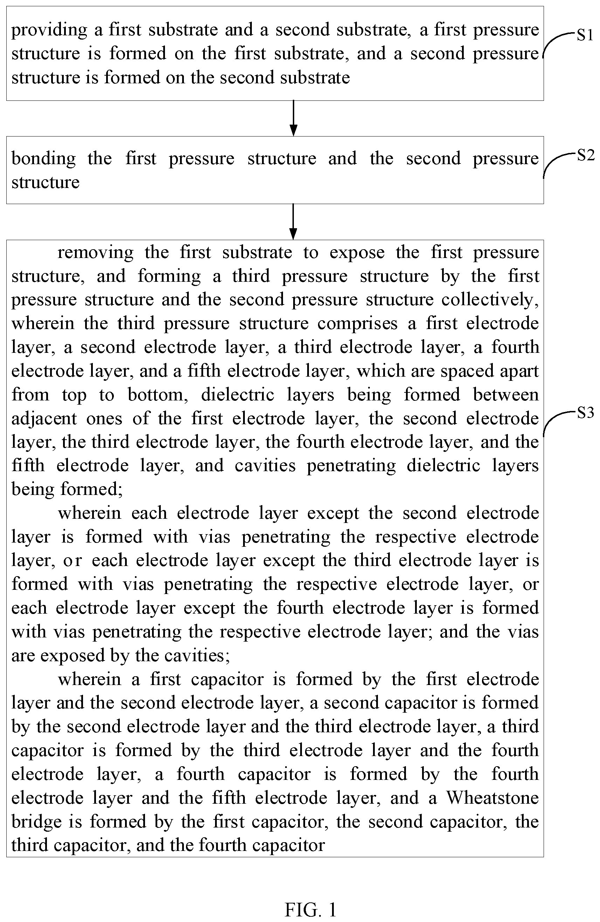

Therefore, in view of the above technical problems, a manufacturing method for a MEMS pressure sensor is provided in the present application. As shown in FIG. 1, the method mainly includes the following steps S1 to S3.

Step S1: a first substrate and a second substrate are provided, a first pressure structure is formed on the first substrate, and a second pressure structure is formed on the second substrate.

Step S2: the first pressure structure and the second pressure structure are bonded.

Step S3: the first substrate is removed to expose the first pressure structure, and the first pressure structure and the second pressure structure collectively form a third pressure structure. The third pressure structure includes a first electrode layer, a second electrode layer, a third electrode layer, a fourth electrode layer, and a fifth electrode layer, which are spaced apart from top to bottom. Dielectric layers are formed between adjacent electrode layers. Cavities penetrating the dielectric layers are formed therein.

Each electrode layer except the second electrode layer is formed with vias penetrating the respective electrode layer. Alternatively, each electrode layer except the third electrode layer is formed with vias penetrating the respective electrode layer. Alternatively, each electrode layer except the fourth electrode layer is formed with vias penetrating the respective electrode layer. The vias are exposed by the cavities.

A first capacitor is formed by the first electrode layer and the second electrode layer. A second capacitor is formed by the second electrode layer and the third electrode layer. A third capacitor is formed by the third electrode layer and the fourth electrode layer. A fourth capacitor is formed by the fourth electrode layer and the fifth electrode layer. A Wheatstone bridge is formed by the first capacitor, the second capacitor, the third capacitor, and the fourth capacitor.

According to the manufacturing method for the MEMS pressure sensor provided in an embodiment of the present application, the third pressure structure is obtained by bonding the first pressure structure and the second pressure structure. The third pressure structure includes the first electrode layer, the second electrode layer, the third electrode layer, the fourth electrode layer, and the fifth electrode layer, which are spaced apart from top to bottom. The first capacitor is formed by the first electrode layer and the second electrode layer. The second capacitor is formed by the second electrode layer and the third electrode layer. The third capacitor is formed by the third electrode layer and the fourth electrode layer. The fourth capacitor is formed by the fourth electrode layer and the fifth electrode layer. The Wheatstone bridge is formed by the first capacitor, the second capacitor, the third capacitor, and the fourth capacitor, that is, a vertical integrated Wheatstone bridge is formed, which improves the measurement accuracy of the MEMS pressure sensor while reducing the planar size thereof, thereby improving the integration density of devices and reducing costs.

### Embodiment 1

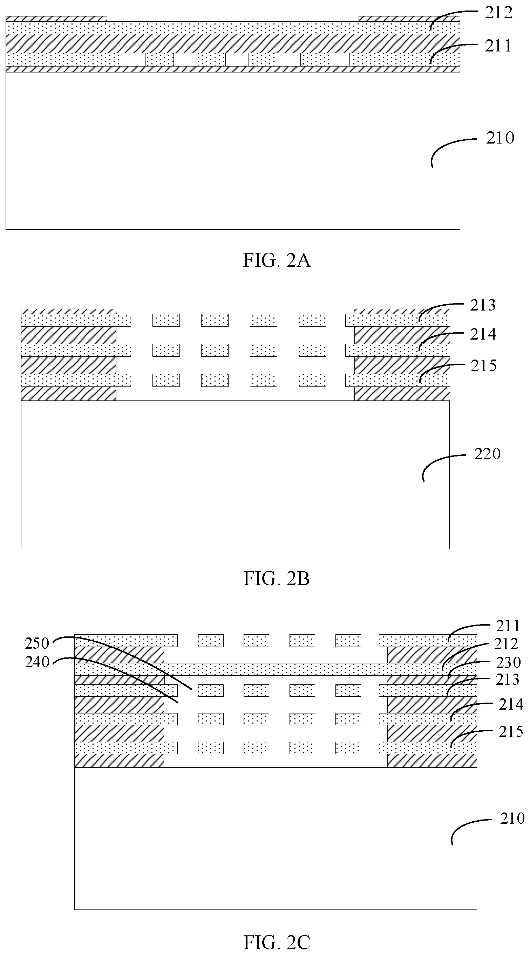

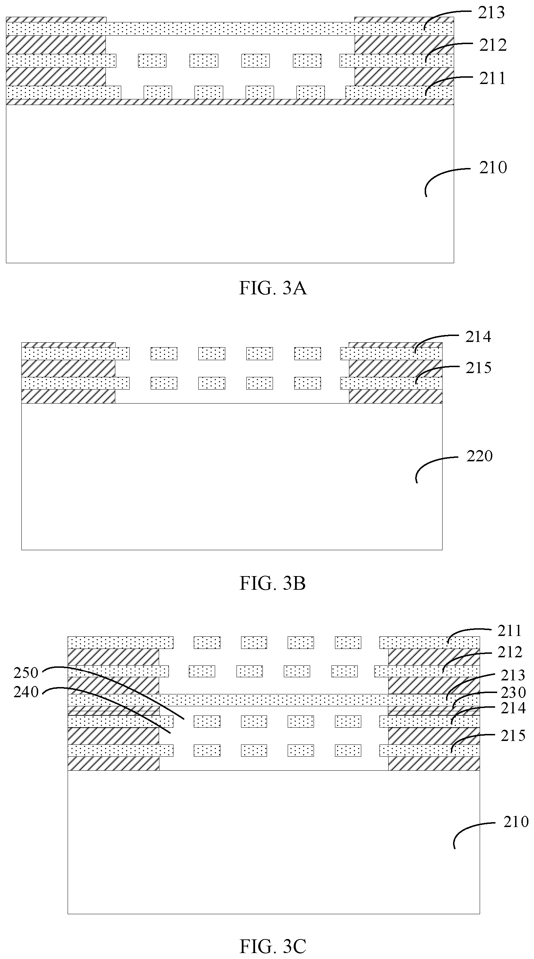

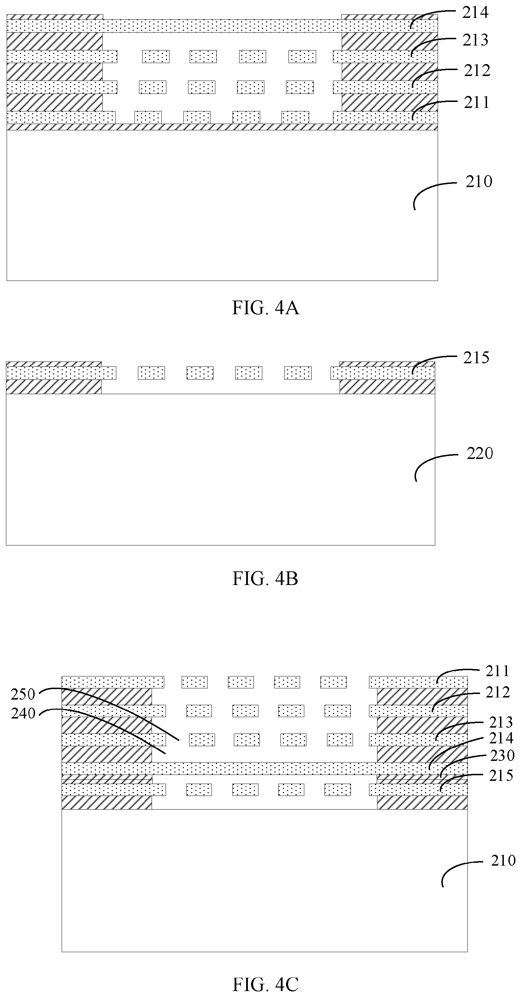

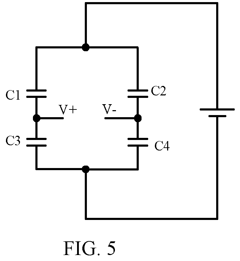

The manufacturing method for the MEMS pressure sensor in the present application is described in detail below with reference to FIG. 1, FIG. 2A to FIG. 2C, FIG. 3A to FIG. 3C, FIG. 4A to FIG. 4C, and FIG. 5. FIG. 1 is a flowchart of a manufacturing method for a MEMS pressure sensor according to an embodiment in the present application. FIG. 2A to FIG. 2C are schematic cross-sectional views of devices sequentially obtained by performing a manufacturing method for a MEMS pressure sensor according to some embodiments in the present application. FIG. 3A to FIG. 3C are schematic cross-sectional views of devices sequentially obtained by performing a manufacturing method for a MEMS pressure sensor according to some other embodiments in the present application. FIG. 4A to FIG. 4C are schematic cross-sectional views of devices sequentially obtained by performing a manufacturing method for a MEMS pressure sensor according to yet some other embodiments in the present application. FIG. 5 is a schematic diagram of the circuit structure of the Wheatstone bridge in the embodiment shown in FIG. 2C.

The manufacturing method for the MEMS pressure sensor provided in an embodiment of the present application includes the following steps.

Step S1 is performed first, where a first substrate and a second substrate are provided, a first pressure structure is formed on the first substrate, and a second pressure structure is formed on the second substrate.

In an example, as shown in FIG. 2A to FIG. 4C, the first substrate 210 and the second substrate 220 are bulk silicon substrates, which may be made of at least one of the following materials: Si, Ge, SiGe, SiC, SiGeC, InAs, GaAs, InP, InGaAs, or other III/V group compound semiconductors, and also include multi-layer structures composed of these semiconductors, or Silicon on Insulator (SOI), Stacked Silicon on Insulator (SSOI), Stacked Silicon Germanium on Insulator (S-SiGeOI), Silicon Germanium on Insulator (SiGeOI), Germanium on Insulator (GeOI), etc.

In an example, as shown in FIG. 2A to FIG. 2C, the first pressure structure includes a first electrode layer 211 and a second electrode layer 212. The second pressure structure includes a third electrode layer 213, a fourth electrode layer 214, and a fifth electrode layer 215. The second electrode layer 212 is arranged above the first electrode layer 211. The fourth electrode layer 214 is arranged above the fifth electrode layer 215. The third electrode layer 213 is arranged above the fourth electrode layer 214. Each electrode layer except the second electrode layer 212 is formed with vias 250 penetrating the respective electrode layer, i.e., the vias 250 are formed in the first electrode layer 211, the third electrode layer 213, the fourth electrode layer 214, and the fifth electrode layer 215. For example, dielectric layers 230 are formed between adjacent electrode layers.

In an example, as shown in FIG. 3A to FIG. 3C, the first pressure structure includes a first electrode layer 211, a second electrode layer 212, and a third electrode layer 213. The second pressure structure includes a fourth electrode layer 214 and a fifth electrode layer 215. The second electrode layer 212 is arranged above the first electrode layer 211. The third electrode layer 213 is arranged above the second electrode layer 212. The fourth electrode layer 214 is arranged above the fifth electrode layer 215. Each electrode layer except the third electrode layer 213 is formed with vias 250 penetrating the respective electrode layer, i.e., the vias 250 are formed in the first electrode layer 211, the second electrode layer 212, the fourth electrode layer 214, and the fifth electrode layer 215.

In an example, as shown in FIG. 4A to FIG. 4C, the first pressure structure includes a first electrode layer 211, a second electrode layer 212, a third electrode layer 213, and a fourth electrode layer 214. The second pressure structure includes a fifth electrode layer 215. The second electrode layer 212 is arranged above the first electrode layer 211. The third electrode layer 213 is arranged above the second electrode layer 212. The fourth electrode layer 214 is arranged above the third electrode layer 213. Each electrode layer except the fourth electrode layer 214 is formed with vias 250 penetrating the respective electrode layer, i.e., the vias 250 are formed in the first electrode layer 211, the second electrode layer 212, the third electrode layer 213, and the fifth electrode layer 215.

In an example, the first electrode layer 211, the second electrode layer 212, the third electrode layer 213, the fourth electrode layer 214, and the fifth electrode layer 215 may be made of materials such as doped polysilicon, SiGe, or may be injected with annealed amorphous silicon, which are not limited to a specific material. The first electrode layer 211 may be formed by Chemical Vapor Deposition (CVD), Physical Vapor Deposition (PVD), Atomic Layer Deposition (ALD), or other methods. Alternatively, the first electrode layer 211 may be formed by one of tube growth and Selective Epitaxial Growth (SEG). The present application is not limited thereto.

In an example, the dielectric layer 230 serves as a support and can be used to improve the strength of the device. For example, the dielectric layer 230 may be an oxide layer, such as silicon oxide, Silicon Oxycarbide (SiOC), and other materials, but is not limited to the above examples. In addition, the dielectric layer 230 may be formed by various deposition methods commonly used in related art, such as Plasma-Enhanced Chemical Vapor Deposition (PECVD), Low-Pressure Chemical Vapor Deposition (LPCVD), physical vapor deposition, or Atomic Layer Deposition (ALD).

Step S2 is performed, where the first pressure structure and the second pressure structure are bonded.

In an example, as shown in FIG. 2C, in a case where the first pressure structure includes the first electrode layer 211 and the second electrode layer 212, and the second pressure structure includes the third electrode layer 213, the fourth electrode layer 214, and the fifth electrode layer 215, during the bonding, the side of the first pressure structure, on which the second electrode layer 212 is formed, is bonded to the side of the second pressure structure, on which the third electrode layer 213 is formed.

In an example, as shown in FIG. 3C, in a case where the first pressure structure includes the first electrode layer 211, the second electrode layer 212, and the third electrode layer 213, and the second pressure structure includes the fourth electrode layer 214 and the fifth electrode layer 215, during the bonding, the side of the first pressure structure, on which the third electrode layer 213 is formed, is bonded to the side of the second pressure structure, on which the fourth electrode layer 214 is formed.

In an example, as shown in FIG. 4C, in a case where the first pressure structure includes the first electrode layer 211, the second electrode layer 212, the third electrode layer 213, and the fourth electrode layer 214, and the second pressure structure includes the fifth electrode layer 215, during the bonding, the side of the first pressure structure, on which the fourth electrode layer 214 is formed, is bonded to the side of the second pressure structure, on which the fifth electrode layer 215 is formed.

In an example, a low-temperature vacuum bonding process is performed for the above bonding. For example, after low-temperature vacuum bonding, a low-temperature annealing process is performed. For example, the temperature of the low-temperature vacuum bonding process is lower than 450 degrees in Celsius.

In an example, as shown in FIG. 2A to FIG. 4C, a dielectric layer 230 is formed on at least one of bonding surfaces of the first pressure structure and the second pressure structure. The first pressure structure and the second pressure structure are bonded through the dielectric layer 230. For example, the drawings of the present application show that the dielectric layer 230 is formed on both bonding surfaces of the first pressure structure and the second pressure structure. In other embodiments, the dielectric layer 230 may be formed only on the bonding surface of the first pressure structure or only on the bonding surface of the second pressure structure.

Step S3 is performed, where the first substrate is removed to expose the first pressure structure. The first pressure structure and the second pressure structure collectively form a third pressure structure, the third pressure structure includes a first electrode layer, a second electrode layer, a third electrode layer, a fourth electrode layer, and a fifth electrode layer, which are spaced apart from top to bottom. The dielectric layers are formed between adjacent electrode layers. The cavities penetrating respective dielectric layers are formed therein.

In an example, as shown in FIG. 2C, FIG. 3C, and FIG. 4C, the first substrate 210 needs to be removed after the bonding to expose the first pressure structure. For example, conventional thinning and etching processes may be used to remove the first substrate 210.

In an example, as shown in FIG. 2A to FIG. 4C, a connection layer may also be formed between the first substrate 210 and the electrode layers, or may be formed between the second substrate 220 and the electrode layers. The material of the connection layer may include any of several dielectric materials which include, but are not limited to, oxides, nitrides, and oxynitrides, especially silicon oxides, silicon nitrides, and silicon oxynitrides. However, the material of the connection layer does not include oxides of other elements, nitrides of other elements, and oxynitrides of other elements. The connection layer may be formed by any of several methods which include, but are not limited to, ion implantation, thermal oxidation, plasma oxidation, thermal nitridation, plasma nitridation, plasma-enhanced chemical vapor deposition, low-pressure chemical vapor deposition, and physical vapor deposition. For example, in a case where a connection layer is also formed between the first substrate 210 and the electrode layers, part of the connection layer should also be removed to expose the vias 250 when removing the first substrate 210.

In an example, the vias 250 may be formed by conventional etching processes used in related art, such as dry etching or wet etching. More specifically, a buffered oxide etchant or Vapor HF (VHF) may be used.

In an example, a cavity 240 is obtained by removing part of the dielectric layer 230 through a via 250. For example, part of the dielectric layer 230 may be removed by conventional etching processes used in the art, such as wet etching. More specifically, a Buffered Oxide Etchant (BOE) may be used to remove the part of the dielectric layer 230, or Vapor HF (VHF) may be used to remove the part of the dielectric layer 230. For example, a release boundary range of the dielectric layer 230 may be reasonably set according to actual requirements. The release boundary refers to the width of the remaining dielectric layer 230.

In an example, the cavities 240 and vias 250 in the second pressure structure are formed before the bonding. In an example, the cavities 240 and vias 250 in the first pressure structure may be formed before or after the bonding. For example, the vias 250 may be formed first, then bonding may be performed, and after that the cavities 240 may be formed. Alternatively, the vias 250 and cavities 240 may be formed first, and then bonding may be performed. Alternatively, the bonding may be performed first, and then the vias 250 and cavities 240 may be formed.

In an example, as shown in FIG. 3C and FIG. 4C, in a case where each electrode layer except the third electrode layer 213 is formed with vias 250 penetrating the respective electrode layer, the vias 250 in the first electrode layer 211 and the second electrode layer 212 are staggered with each other. In a case where each electrode layer except the fourth electrode layer 214 is formed with vias 250 penetrating the respective electrode layer, the vias 250 in the first electrode layer 211, the vias 250 in the second electrode layer 212, and the vias 250 in the third electrode layer 213 are staggered with each other. For example, being staggered with each other here means that the positions of the vias are not aligned. For example, in the case where each electrode layer except the third electrode layer 213 is formed with vias 250 penetrating the respective electrode layer, the first electrode layer 211 and the second electrode layer 212 are in direct contact with the external environment. By staggering the vias 250 in the first electrode layer 211 and the second electrode layer 212, foreign matter in the external environment can be effectively prevented from entering the device and degrading the performance of the device. Similarly, in a case where each electrode layer except the fourth electrode layer 214 is formed with vias 250 penetrating the respective electrode layer, the first electrode layer 211, the second electrode layer 212, and the third electrode layer 213 are in direct contact with the external environment. By staggering the vias 250 in the first electrode layer 211, the second electrode layer 212, and the third electrode layer 213, the foreign matter in the external environment can be effectively prevented from entering the device and degrading the performance of the device.

In an example, as shown in FIG. 2C, FIG. 3C, and FIG. 4C, a first capacitor C1 is formed by the first electrode layer 211 and the second electrode layer 212. A second capacitor C2 is formed by the second electrode layer 212 and the third electrode layer 213. A third capacitor C3 is formed by the third electrode layer 213 and the fourth electrode layer 214. A fourth capacitor C4 is formed by the fourth electrode layer 214 and the fifth electrode layer 215. The Wheatstone bridge shown in FIG. 5 is formed by the first capacitor C1, the second capacitor C2, the third capacitor C3, and the fourth capacitor C4. For example, since the first electrode layer 211, the second electrode layer 212, the third electrode layer 213, the fourth electrode layer 214, and the fifth electrode layer 215 are spaced apart from top to bottom, the formed first capacitor C1, second capacitor C2, third capacitor C3, and fourth capacitor C4 are also vertically integrated, which can greatly reduce the planar size of the MEMS pressure sensor, improving the integration density of the device, thereby reducing the cost of the device. For example, the positions of the first capacitor C1, second capacitor C2, third capacitor C3, and fourth capacitor C4 in the Wheatstone bridge shown in FIG. 5 are only for illustrative purposes. In other embodiments, the first capacitor C1, second capacitor C2, third capacitor C3, and fourth capacitor C4 may form a Wheatstone bridge through other connection methods. For example, the first capacitor C1 and fourth capacitor C4 are on a same bridge arm, and the second capacitor C2 and third capacitor C3 are on a same bridge arm. The present application is not limited thereto.

For example, as shown in FIG. 2C, the first capacitor C1 formed by the first electrode layer 211 and the second electrode layer 212 has a variable capacitance. When subjected to an external pressure, the second electrode layer 212 deforms, increasing the distance between the first electrode layer 211 and the second electrode layer 212, thereby reducing the capacitance of the first capacitor C1. The second capacitor C2 formed by the second electrode layer 212 and the third electrode layer 213 also has a variable capacitance. When subjected to an external pressure, the second electrode layer 212 deforms, decreasing the distance between the third electrode layer 213 and the second electrode layer 212, thereby increasing the capacitance of the second capacitor C2. The third capacitor C3 formed by the third electrode layer 213 and the fourth electrode layer 214, and the fourth capacitor C4 formed by the fourth electrode layer 214 and the fifth electrode layer 215 are both reference capacitors with a fixed capacitance. When subjected to an external pressure, the capacitances of the third capacitor C3 and the fourth capacitor C4 remain unchanged.

In another example, as shown in FIG. 3C, the second capacitor C2 formed by the second electrode layer 212 and the third electrode layer 213 has a variable capacitance. When subjected to an external pressure, the third electrode layer 213 deforms, increasing the distance between the second electrode layer 212 and the third electrode layer 213, thereby reducing the capacitance of the second capacitor C2. The third capacitor C3 formed by the third electrode layer 213 and the fourth electrode layer 214 also has a variable capacitance. When subjected to an external pressure, the third electrode layer 213 deforms, decreasing the distance between the fourth electrode layer 214 and the third electrode layer 213, thereby increasing the capacitance of the third capacitor C3. The first capacitor C1 formed by the first electrode layer 211 and the second electrode layer 212, and the fourth capacitor C4 formed by the fourth electrode layer 214 and the fifth electrode layer 215 are both reference capacitors with a fixed capacitance. When subjected to an external pressure, the capacitances of the first capacitor C1 and the fourth capacitor C4 remain unchanged.

In another example, as shown in FIG. 4C, the third capacitor C3 formed by the third electrode layer 213 and the fourth electrode layer 214 has a variable capacitance. When subjected to an external pressure, the fourth electrode layer 214 deforms, increasing the distance between the third electrode layer 213 and the fourth electrode layer 214, thereby reducing the capacitance of the third capacitor C3. The fourth capacitor C4 formed by the fourth electrode layer 214 and the fifth electrode layer 215 also has a variable capacitance. When subjected to an external pressure, the fourth electrode layer 214 deforms, decreasing the distance between the fifth electrode layer 215 and the fourth electrode layer 214, thereby increasing the capacitance of the fourth capacitor C4. The first capacitor C1 formed by the first electrode layer 211 and the second electrode layer 212, and the second capacitor C2 formed by the second electrode layer 212 and the third electrode layer 213 are both reference capacitors with a fixed capacitance. When subjected to an external pressure, the capacitances of the first capacitor C1 and the second capacitor C2 remain unchanged.

In an example, taking the device structure shown in FIG. 2C and the Wheatstone bridge structure shown in FIG. 5 as an example, a bridge arm of the Wheatstone bridge is provided with the first capacitor C1 and the third capacitor C3, and the other bridge arm is provided with the second capacitor C2 and the fourth capacitor C4. The first capacitor C1 and the second capacitor C2 are capacitors with a variable capacitance. The third capacitor C3 and the fourth capacitor C4 are reference capacitors with a fixed capacitance. When subjected to an external pressure, the capacitances of the first capacitor C1 and the second capacitor C2 both change, causing the voltage value of the output voltage between the terminal V+ and the terminal V- to change. By measuring the output voltage, the change in the capacitance values of the first capacitor C1 and the second capacitor C2 can be obtained, and the corresponding pressure value can be then obtained, thus completing the pressure measurement. For example, compared with pressure measurement using a single capacitive structure, when measuring the pressure on the Wheatstone bridge, since the obtained output is differential, the measurement accuracy is relatively high and the interference of common-mode noise can be reduced effectively. For example, the initial capacitances of the first capacitor C1, the second capacitor C2, the third capacitor C3, and the fourth capacitor C4 may be configured to be equal when not subjected to a pressure, so that the Wheatstone bridge is in a balanced state when not subjected to a pressure, and the change in the output voltage is easier to measure when subjected to a pressure. Furthermore, the changes of the two capacitors with a variable capacitance in the first capacitor C1, the second capacitor C2, the third capacitor C3, and the fourth capacitor C4 may be made equal when subjected to a pressure, so that the change in the output voltage is easier to measure.

It should be noted that the above steps are only examples, and the order of the steps may be adjusted without contradictions.

The critical steps of the manufacturing method for the MEMS pressure sensor of the present application have been described above. For the manufacturing of the entire MEMS pressure sensor, other steps may also be included, such as forming the bonding pads for leading out the electrode layers, which are not repeated herein.

In summary, the third pressure structure is obtained by bonding the first pressure structure and the second pressure structure. The third pressure structure includes the first electrode layer, the second electrode layer, the third electrode layer, the fourth electrode layer, and the fifth electrode layer, which are spaced apart from top to bottom. The first capacitor is formed by the first electrode layer and the second electrode layer. The second capacitor is formed by the second electrode layer and the third electrode layer. The third capacitor is formed by the third electrode layer and the fourth electrode layer. The fourth capacitor is formed by the fourth electrode layer and the fifth electrode layer. The Wheatstone bridge is formed by the first capacitor, the second capacitor, the third capacitor, and the fourth capacitor, that is, a vertical integrated Wheatstone bridge is formed, which improves the measurement accuracy of the MEMS pressure sensor while reducing the planar size thereof, thereby improving the integration density of devices and reducing costs.

### Embodiment 2

A MEMS pressure sensor is also provided in the present application. The MEMS pressure sensor of an embodiment in the present application is described below with reference to FIG. 2B to FIG.2C, and FIG. 3C, FIG. 4C, and FIG. 5. The MEMS pressure sensor is manufactured by the method in Embodiment 1. The MEMS pressure sensor of this embodiment includes a substrate 220 and a pressure structure arranged on the substrate 220. The pressure structure includes a first electrode layer 211, a second electrode layer 212, a third electrode layer 213, a fourth electrode layer 214, and a fifth electrode layer 215, which are spaced apart from top to bottom. Dielectric layers 230 are formed between respective pairs of adjacent electrode layers. Cavities 240 penetrating respective dielectric layers 230 are formed therein.

Each electrode layer except the second electrode layer 212 is formed with vias 250 penetrating the respective electrode layer. Alternatively, each electrode layer except the third electrode layer 213 is formed with vias 250 penetrating the respective electrode layer. Alternatively, each electrode layer except the fourth electrode layer 214 is formed with vias 250 penetrating the respective electrode layer. The vias 250 are exposed by the cavities 240. The first capacitor is formed by the first electrode layer 211 and the second electrode layer 212. The second capacitor is formed by the second electrode layer 212 and the third electrode layer 213. The third capacitor is formed by the third electrode layer 213 and the fourth electrode layer 214. The fourth capacitor is formed by the fourth electrode layer 214 and the fifth electrode layer 215. The Wheatstone bridge is formed by the first capacitor, the second capacitor, the third capacitor, and the fourth capacitor.

In an example, the substrate 220 is a bulk silicon substrate, which may made of at least one of the following materials: Si, Ge, SiGe, SiC, SiGeC, InAs, GaAs, InP, InGaAs, or other III/V group compound semiconductors, and also include multi-layer structures being composed of these semiconductors, or Silicon on Insulator (SOI), Stacked Silicon on Insulator (SSOI), Stacked Silicon Germanium on Insulator (S-SiGeOI), Silicon Germanium on Insulator (SiGeOI), Germanium on Insulator (GeOI), etc.

In an example, as shown in FIG. 3C and FIG. 4C, in a case where each electrode layer except the third electrode layer 213 is formed with vias 250 penetrating the respective electrode layer, the vias 250 in the first electrode layer 211 and the second electrode layer 212 are staggered with each other. In a case where each electrode layer except the fourth electrode layer 214 is formed with vias 250 penetrating the respective electrode layer, the vias 250 in the first electrode layer 211, the second electrode layer 212, and the third electrode layer 213 are staggered with each other. For example, "staggered with each other" as used herein means that the positions of the vias are not aligned. For example, in the case where each electrode layer except the third electrode layer 213 is formed with vias 250 penetrating the respective electrode layer, the first electrode layer 211 and the second electrode layer 212 are in direct contact with the external environment. By staggering the vias 250 in the first electrode layer 211 and the second electrode layer 212, foreign matter in the external environment can be effectively prevented from entering the device and degrading the performance of the device. Similarly, in a case where each electrode layer except the fourth electrode layer 214 is formed with vias 250 penetrating the respective electrode layer, the first electrode layer 211, the second electrode layer 212, and the third electrode layer 213 are in direct contact with the external environment. By staggering the vias 250 in the first electrode layer 211, the second electrode layer 212, and the third electrode layer 213, the foreign matter in the external environment can be effectively prevented from entering the device and degrading the performance of the device.

In an example, as shown in FIG. 2C, FIG. 3C, and FIG. 4C, a first capacitor C1 is formed by the first electrode layer 211 and the second electrode layer 212. A second capacitor C2 is formed by the second electrode layer 212 and the third electrode layer 213. A third capacitor C3 is formed by the third electrode layer 213 and the fourth electrode layer 214. A fourth capacitor C4 is formed by the fourth electrode layer 214 and the fifth electrode layer 215. The Wheatstone bridge shown in FIG. 5 is formed by the first capacitor C1, the second capacitor C2, the third capacitor C3, and the fourth capacitor C4. For example, since the first electrode layer 211, the second electrode layer 212, the third electrode layer 213, the fourth electrode layer 214, and the fifth electrode layer 215 are spaced apart from top to bottom, the formed first capacitor C1, second capacitor C2, third capacitor C3, and fourth capacitor C4 are also vertically integrated, which can greatly reduce the planar size of the MEMS pressure sensor, improving the integration density of the device, thereby reducing the cost of the device. For example, the positions of the first capacitor C1, second capacitor C2, third capacitor C3, and fourth capacitor C4 in the Wheatstone bridge shown in FIG. 5 are only for illustrative purposes. In other embodiments, the first capacitor C1, second capacitor C2, third capacitor C3, and fourth capacitor C4 may form a Wheatstone bridge through other connection methods. For example, the first capacitor C1 and fourth capacitor C4 are on a same bridge arm, and the second capacitor C2 and third capacitor C3 are on a same bridge arm. The present application is not limited thereto.

In an example, as shown in FIG. 2C, the first capacitor C1 formed by the first electrode layer 211 and the second electrode layer 212 has a variable capacitance. When subjected to an external pressure, the second electrode layer 212 deforms, increasing the distance between the first electrode layer 211 and the second electrode layer 212, thereby reducing the capacitance of the first capacitor C1. The second capacitor C2 formed by the second electrode layer 212 and the third electrode layer 213 is also a variable capacitor. When subjected to an external pressure, the second electrode layer 212 deforms, decreasing the distance between the third electrode layer 213 and the second electrode layer 212, thereby increasing the capacitance of the second capacitor C2. The third capacitor C3 formed by the third electrode layer 213 and the fourth electrode layer 214, and the fourth capacitor C4 formed by the fourth electrode layer 214 and the fifth electrode layer 215 are both reference capacitors with a fixed capacitance. When subjected to an external pressure, the capacitances of the third capacitor C3 and the fourth capacitor C4 remain unchanged.

In another example, as shown in FIG. 3C, the second capacitor C2 formed by the second electrode layer 212 and the third electrode layer 213 has a variable capacitance. When subjected to an external pressure, the third electrode layer 213 deforms, increasing the distance between the second electrode layer 212 and the third electrode layer 213, thereby reducing the capacitance of the second capacitor C2. The third capacitor C3 formed by the third electrode layer 213 and the fourth electrode layer 214 is also a variable capacitor. When subjected to an external pressure, the third electrode layer 213 deforms, decreasing the distance between the fourth electrode layer 214 and the third electrode layer 213, thereby increasing the capacitance of the third capacitor C3. The first capacitor C1 formed by the first electrode layer 211 and the second electrode layer 212, and the fourth capacitor C4 formed by the fourth electrode layer 214 and the fifth electrode layer 215 are both reference capacitors with a fixed capacitance. When subjected to an external pressure, the capacitances of the first capacitor C1 and the fourth capacitor C4 remain unchanged.

In another example, as shown in FIG. 4C, the third capacitor C3 formed by the third electrode layer 213 and the fourth electrode layer 214 has a variable capacitance. When subjected to an external pressure, the fourth electrode layer 214 deforms, increasing the distance between the third electrode layer 213 and the fourth electrode layer 214, thereby reducing the capacitance of the third capacitor C3. The fourth capacitor C4 formed by the fourth electrode layer 214 and the fifth electrode layer 215 is also a variable capacitor. When subjected to an external pressure, the fourth electrode layer 214 deforms, decreasing the distance between the fifth electrode layer 215 and the fourth electrode layer 214, thereby increasing the capacitance of the fourth capacitor C4. The first capacitor C1 formed by the first electrode layer 211 and the second electrode layer 212, and the second capacitor C2 formed by the second electrode layer 212 and the third electrode layer 213 are both reference capacitors with a fixed capacitance. When subjected to an external pressure, the capacitances of the first capacitor C1 and the second capacitor C2 remain unchanged.

In an example, taking the device structure shown in FIG. 2C and the Wheatstone bridge structure shown in FIG. 5 as an example, a bridge arm of the Wheatstone bridge is provided with the first capacitor C1 and the third capacitor C3, and the other bridge arm is provided with the second capacitor C2 and the fourth capacitor C4. The first capacitor C1 and the second capacitor C2 are capacitors with a variable capacitance. The third capacitor C3 and the fourth capacitor C4 are reference capacitors with a fixed capacitance. When subjected to an external pressure, the capacitances of the first capacitor C1 and the second capacitor C2 are both change, causing the voltage value of the output voltage between the terminal V+ and the terminal V- to change. By measuring the output voltage, the change in the capacitance values of the first capacitor C1 and the second capacitor C2 can be obtained, and thus the corresponding pressure value can be obtained, then the pressure measurement is completed. For example, compared with pressure measurement using a single capacitive structure, when measuring the pressure on the Wheatstone bridge, the measurement accuracy is relatively high and the interference of common-mode noise can be reduced effectively due to the obtainment of differential output. For example, the initial capacitances of the first capacitor C1, the second capacitor C2, the third capacitor C3, and the fourth capacitor C4 may be configured to be equal when not subjected to a pressure, so that the Wheatstone bridge is in a balanced state when not subjected to a pressure, and the change in the output voltage is easier to measure when subjected to a pressure. Furthermore, the change of the two capacitors with a variable capacitance in the first capacitor C1, the second capacitor C2, the third capacitor C3, and the fourth capacitor C4 may be made equal when subjected to a pressure, so that the change in the output voltage is easier to measure.

Thus concludes the description of the structure of the MEMS pressure sensor in the present application. For a complete device, other constituent structures may also be included, such as bonding pads for leading out an electrode layer, which are not repeated herein.

A pressure structure is formed in the MEMS pressure sensor of the present application. The pressure structure includes the first electrode layer, the second electrode layer, the third electrode layer, the fourth electrode layer, and the fifth electrode layer, which are spaced apart from top to bottom. The first capacitor is formed by the first electrode layer and the second electrode layer. The second capacitor is formed by the second electrode layer and the third electrode layer. The third capacitor is formed by the third electrode layer and the fourth electrode layer. The fourth capacitor is formed by the fourth electrode layer and the fifth electrode layer. The Wheatstone bridge is formed by the first capacitor, the second capacitor, the third capacitor, and the fourth capacitor, that is, a vertical integrated Wheatstone bridge is formed, which improves the measurement accuracy of the MEMS pressure sensor while reducing the planar size thereof, thereby improving the integration density of devices and reducing costs.

### Embodiment 3

An electronic device is provided in the present application, which includes a MEMS pressure sensor of Embodiment 2 or a MEMS pressure sensor manufactured by the method of Embodiment 1.

The electronic device may be any one of electronic products or devices such as a mobile phone, a tablet computer, a laptop computer, a netbook, a game console, a television, a VCD, a DVD, a navigator, a camera, a camcorder, a voice recorder, an MP3 player, an MP4 player, a PlayStation Portable (PSP), or an intermediate product including the above MEMS pressure sensor, for example, a mobile phone mainboard with an integrated circuit. The electronic device of an embodiment in the present application has better performance due to the use of the above MEMS pressure sensor.

The technical features of the above embodiments may be combined arbitrarily. For conciseness of description, not all possible combinations of the technical features in the above embodiments are described. However, as long as there is no contradiction between the combinations of the technical features, those combinations should be considered in the scope described in this specification.

The above embodiments only represent several implementations of the present application, and their descriptions are more specific and detailed, but should not be construed as limiting the scope of the present application. It should be noted that for those skilled in the art, without departing from the inventive concept of the present application, several variations and improvements can be made, and these all belong to the protection scope of the present application. Therefore, the protection scope of the present application should be subject to the appended claims.

## Claims

1. A manufacturing method for a micro-electro-mechanical system (MEMS) pressure sensor, comprising:
providing a first substrate and a second substrate, forming a first pressure structure on the first substrate, and forming a second pressure structure on the second substrate;
bonding the first pressure structure and the second pressure structure;
removing the first substrate to expose the first pressure structure, and the first pressure structure and the second pressure structure collectively forming a third pressure structure, wherein the third pressure structure comprises a first electrode layer, a second electrode layer, a third electrode layer, a fourth electrode layer, and a fifth electrode layer, which are spaced apart from top to bottom, dielectric layers are formed between adjacent electrode layers, and cavities penetrating respective dielectric layers are formed;
wherein each electrode layer except the second electrode layer is formed with vias penetrating the respective electrode layer, or each electrode layer except the third electrode layer is formed with vias penetrating the respective electrode layer, or each electrode layer except the fourth electrode layer is formed with vias penetrating the respective electrode layer; and the vias are exposed by the cavities;
wherein a first capacitor is formed by the first electrode layer and the second electrode layer, a second capacitor is formed by the second electrode layer and the third electrode layer, a third capacitor is formed by the third electrode layer and the fourth electrode layer, a fourth capacitor is formed by the fourth electrode layer and the fifth electrode layer, and a Wheatstone bridge is formed by the first capacitor, the second capacitor, the third capacitor, and the fourth capacitor.

2. The manufacturing method according to claim 1, wherein the dielectric layer is formed on at least one of bonding surfaces of the first pressure structure and the second pressure structure, and the first pressure structure and the second pressure structure are bonded by the dielectric layer.

3. The manufacturing method according to claim 1, wherein the bonding is performed by a low-temperature vacuum bonding process.

4. The manufacturing method according to claim 1, wherein in a case where each electrode layer except the third electrode layer is formed with vias penetrating the respective electrode layer, the vias in the first electrode layer and the vias in the second electrode layer are staggered with each other, or in a case where each electrode layer except the fourth electrode layer is formed with vias penetrating the respective electrode layer, the vias in the first electrode layer, the vias in the second electrode layer, and the vias in the third electrode layer are staggered with each other.

5. The manufacturing method according to claim 1, wherein the first pressure structure comprises the first electrode layer and the second electrode layer, the second pressure structure comprises the third electrode layer, the fourth electrode layer, and the fifth electrode layer, during the bonding, a side of the first pressure structure, on which the second electrode layer is formed, is bonded to a side of the second pressure structure, on which the third electrode layer is formed, and each electrode layer except the second electrode layer is formed with vias penetrating the respective electrode layer.

6. The manufacturing method according to claim 1, wherein the first pressure structure comprises the first electrode layer, the second electrode layer, and the third electrode layer, the second pressure structure comprises the fourth electrode layer and the fifth electrode layer, during the bonding, a side of the first pressure structure, on which the third electrode layer is formed, is bonded to a side of the second pressure structure, on which the fourth electrode layer is formed, and each electrode layer except the third electrode layer is formed with vias penetrating the respective electrode layer.

7. The manufacturing method according to claim 1, wherein the first pressure structure comprises the first electrode layer, the second electrode layer, the third electrode layer, and the fourth electrode layer, the second pressure structure comprises the fifth electrode layer, during the bonding, a side of the first pressure structure, on which the fourth electrode layer is formed, is bonded to a side of the second pressure structure, on which the fifth electrode layer is formed, and each electrode layer except the third electrode layer is formed with vias penetrating the respective electrode layer.

8. The manufacturing method according to claim 1, wherein connection layers are formed between the first substrate and the first electrode layer, and between the second substrate and the fifth electrode layer, respectively.

9. The manufacturing method according to claim 8, wherein materials of the connection layers comprise silicon oxide, nitride, or oxynitride.

10. The manufacturing method according to claim 1, wherein the vias are formed by a dry etching process or a wet etching process.

11. The manufacturing method according to claim 1, wherein the first capacitor, the second capacitor, the third capacitor, and the fourth capacitor are vertically integrated.

12. The manufacturing method according to claim 1, wherein the first capacitor and the second capacitor are capacitors with a variable capacitance, and the third capacitor and the fourth capacitor are reference capacitors with a fixed capacitance, or
the second capacitor and the third capacitor are capacitors with a variable capacitance, and the first capacitor and the fourth capacitor are reference capacitors with a fixed capacitance, or
the third capacitor and the fourth capacitor are capacitors with a variable capacitance, and the first capacitor and the second capacitor are reference capacitors with a fixed capacitance.

13. A MEMS pressure sensor, comprising:
a substrate;
a pressure structure arranged on the substrate and comprising a first electrode layer, a second electrode layer, a third electrode layer, a fourth electrode layer, a fifth electrode layer, which are spaced apart from top to bottom, dielectric layers being formed between adjacent electrode layers, and cavities penetrating respective dielectric layers being formed;
wherein each electrode layer except the second electrode layer is formed with vias penetrating the respective electrode layer, or each electrode layer except the third electrode layer is formed with vias penetrating the respective electrode layer, or each electrode layer except the fourth electrode layer is formed with vias penetrating the respective electrode layer; and the vias are exposed by the cavities;
wherein a first capacitor is formed by the first electrode layer and the second electrode layer, a second capacitor is formed by the second electrode layer and the third electrode layer, a third capacitor is formed by the third electrode layer and the fourth electrode layer, a fourth capacitor is formed by the fourth electrode layer and the fifth electrode layer, and a Wheatstone bridge is formed by the first capacitor, the second capacitor, the third capacitor, and the fourth capacitor.

14. The MEMS pressure sensor according to claim 13, wherein in a case where each electrode layer except the third electrode layer is formed with vias penetrating the respective electrode layer, the vias in the first electrode layer and the vias in the second electrode layer are staggered with each other;
in a case where each electrode layer except the fourth electrode layer is formed with vias penetrating the respective electrode layer, the vias in the first electrode layer, the vias in the second electrode layer, and the vias in the third electrode layer are staggered with each other.

15. An electronic device, comprising the MEMS pressure sensor according to claim 13 or 14.
